# EUROPEAN PATENT APPLICATION

(11) **EP 2 169 722 A1**
(43) Date of publication of application: **31.03.2010**
(21) Application number: 08777273.7
(22) Date of filing: 17.06.2008
(51) Int. Cl.: H01L 29/861, H01L 21/822, H01L 27/04, H01L 29/744

(54) **PN DIODE, ELECTRIC CIRCUIT DEVICE AND POWER CONVERSION DEVICE**

(30) Priority: 20.06.2007 JP 2007162847
(71) Applicant: The Kansai Electric Power Co., Inc., Kita-ku Osaka-shi Osaka 530-8270 (JP)
(72) Inventor: ASANO, Katsunori, Amagasaki-shi Hyogo 661-0974 (JP); SUGAWARA, Yoshitaka, Amagasaki-shi Hyogo 661-0974 (JP); TANAKA, Atsushi, Amagasaki-shi Hyogo 661-0974 (JP)
(74) Representative: Suckling, Andrew Michael
(86) International application number: PCT/JP2008/061035
(87) International publication number: WO 2008/156076

(57) **Abstract**

In a SiC pn diode, the lifetime is controlled by electron beam irradiation of about 3×10¹³ cm⁻² or more. As a result of the life time control, as shown by a current-voltage characteristic (K10) in Fig. 1, the current started to flow at about 32 V and the on-voltage at an applied current of 100 A was 50 V in the SiC pn diode. In this case, the SiC pn diode has a resistance of 0.5 Ω when the SiC pn diode is turned on. The conducting region of the SiC pn diode is 0.4 cm², and is reduced to 0.2 Ωcm² by increasing the on-resistance by the lifetime control. Therefore, for instance, in an electric circuit device using a diode and a resistor connected in series in prior arts, the resistor can be eliminated.

## Description

### TECHNICAL FIELD

The present invention relates to a pn diode, an electric circuit device and a power conversion device and, as an example, to a high-resistance diode and a power conversion device including the same.

### BACKGROUND ART

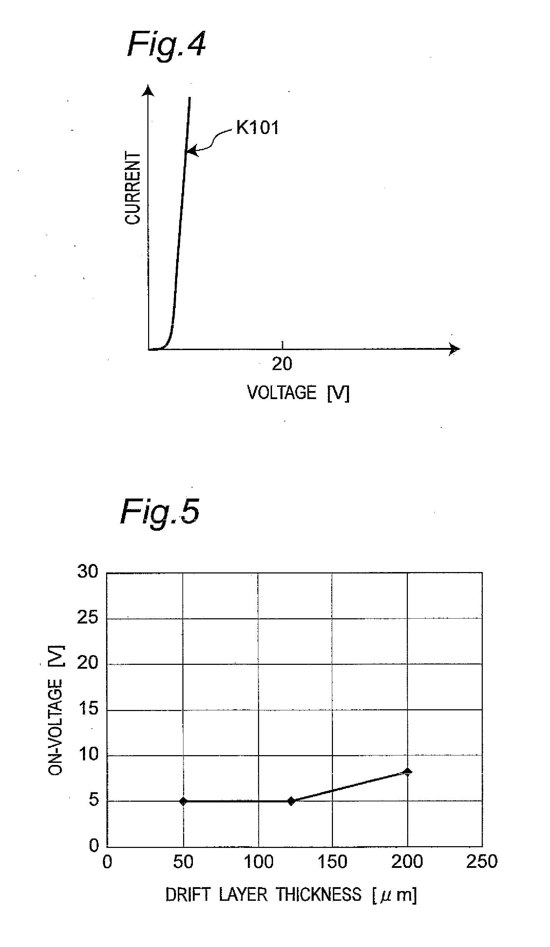

As to forward characteristics of a diode, as shown by a characteristic K101 in Fig. 4, a current starts to flow along with a voltage higher than a threshold voltage, and an on-voltage at a rated current applied is restrained to at most about 5V or less. The reason of restraining the on-voltage like this is to restrain the junction temperature of the diode so as not to exceed a rated maximum junction temperature (about 125°C for Si). That is, the on-voltage is held such low as to prevent the junction temperature from going beyond the rated maximum junction temperature due to losses caused by applying a current.

Wide-gap semiconductors such as SiC, GaN and diamond, which are wider in bandgap and higher in heat tolerance than Si, are enabled to increase the current density at an applied current, while holding the on-voltage at around several volts or lower.

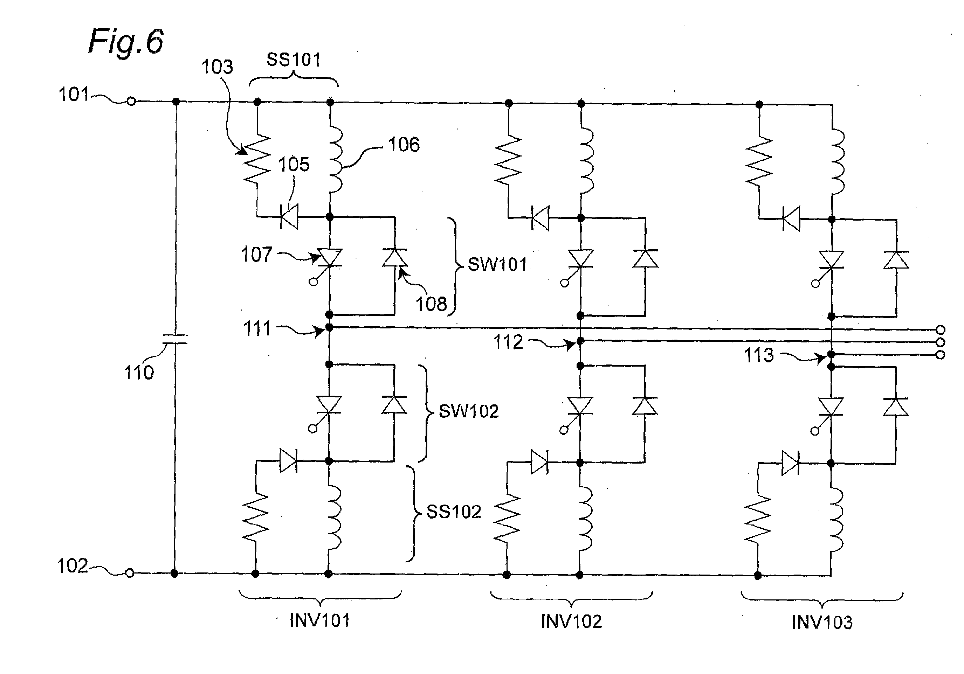

Fig. 6 is a circuit diagram showing a typical prior-art three-phase inverter device in which GTOs (Gate Turn-Off thyristors) are used as switching elements. This three-phase inverter device has, between a positive terminal 101 and a negative terminal 102 of direct current: a series snubber circuit SS101 formed of a parallel connection unit in which a series connection unit of a diode 105 and a resistor 103 is connected in parallel to a reactor 106; and a first switching circuit SW101 formed by antiparallel connection of a GTO 107 and a diode 108. A second switching circuit SW102 is connected to the first switching circuit SW101, where the second switching circuit SW102 is similar in construction to the first switching circuit SW101. A series snubber circuit SS102 is connected to the second switching circuit SW102, where the series snubber circuit SS102 is similar in construction to the series snubber circuit SS101. These first and second switching circuits SW101, SW102 and the two series snubber circuits SS101, SS102 constitute an inverter circuit INV101 for one phase. Similarly, between the positive terminal 101 and the negative terminal 102, two inverter circuits INV102, INV103 similar to the one-phase inverter circuit INV101 are connected, thus a total of three inverter circuits INV101 - INV103 constituting a three-phase inverter device. In addition, a capacitor 110 is connected between the positive terminal 101 and the negative terminal 102.

In this three-phase inverter device, an alternating current is outputted from a connecting point 111 between the first switching circuit SW101 and the second switching circuit SW102, while alternating currents are outputted also from connecting points 112, 113, thus a total of three-phase alternating currents being outputted. In this three-phase inverter device, all the six series snubber circuits SS101, SS102, ... for three phases are similar in construction and similar in operation. Therefore, a description is given below about the series snubber circuits SS101, SS102 for the first phase closest to the DC side. Also, the six switching circuits SW101, SW102, ..., i.e., the first and second switching circuits for three phases are all similar in construction and similar in operation. Therefore, the following description is directed to the switching circuits SW101, SW102 for the first phase closest to the DC side, as a representative.

In the series snubber circuit SS101, a series connection unit of the diode 105 and the resistor 103 is connected in parallel to an anode reactor 106 which is an inductor. Also, the first switching circuit SW101 has the GTO 107 as a switching element, and a free wheeling diode 108 is connected in antiparallel between anode and cathode of the GTO 107.

Besides, in some cases, in addition to the free wheeling diode 108, a parallel snubber circuit is connected between anode and cathode of the GTO 107. This parallel snubber circuit is a circuit which is connected to increase a interrupting current of the GTO 107 or reduce a voltage rising rate or an overvoltage between the anode and the cathode of the GTO 107.

A control signal from an unshown known control circuit is applied to a gate terminal of the GTO 107. By this control signal, the first switching circuit SW101 having the GTO 107 as well as the GTOs that are switching elements of the other five switching circuits are turned on and off at specified timings to perform current conversion from DC to AC and produce outputs on output lines connected to the connecting points 111, 112, 113. When the GTO 107 is turned on, a current derived from the direct current DC flows through the anode reactor 106 and the GTO 107. In this case, the anode reactor 106 of the series snubber circuit SS101 has a function of moderating the rise (di/dt) of the current at turn-on of the GTO 107 to keep the rise within a critical current rising rate of the GTO 107.

Also, the anode reactor 106 is used also for the purpose of restraining a short-circuit current peak value within a maximum controllable current value at a time point when the self arc-suppression type semiconductor device starts to interrupt an electric current upon occurrence of a load short-circuiting, an AC-side interconnected system grounding or interphase short-circuiting, or a DC short-circuiting, so as to interrupt a fault current without causing any device destruction.

When the GTO 107 is turned off, a current by electromagnetic energy stored in the anode reactor 106 flows through the diode 105 and the resistor 103 both of which are connected in parallel to the anode reactor 106. This resistor 103 consumes the electromagnetic energy by the time of a next turn-on of the GTO 107 to decay the current flowing through the anode reactor 106.

Also, in a current-limiting circuit (not shown) for suppression of overcurrents, a fault current is limited by the reactor, and the current is interrupted by a semiconductor element, a circuit breaker or the like. To prevent any overvoltage in this current interruption, a series unit of a diode and a resistor is connected in parallel to the reactor, and a fault current that has flowed through the reactor is circulated by the diode to the resistor so that energy stored in the reactor is consumed by the resistor.

An anode reactor of a power conversion device using a conventional self arc-suppression type semiconductor element, as described in Patent Literature 1 (JP 2000-166248 A), needs to be set to the largest inductance value out of inductance values that depend on a critical on-current rising rate and a critical off-voltage rising rate of the self arc-suppression type semiconductor element, a reverse recovery capability of the free wheeling diode, and a short-circuit current peak value at a DC short-circuiting, respectively.

In particular, a power conversion device having no parallel snubber circuits includes no snubber capacitor for suppressing voltage rising. Therefore, smaller inductance values of the anode reactor would cause a result that the voltage rising rate during recovery of the reverse voltage of the free wheeling diode becomes so high as to go beyond the reverse recovery capability of the free wheeling diode or that the self arc-suppression type semiconductor element connected in antiparallel to the free wheeling diode is mis-triggered. For this reason, the inductance value of the anode reactor needs to be set larger than those of power conversion devices having parallel snubber circuits.

However, increased inductance values of the anode reactor would involve increases in energy to be stored therein. In a case where the energy is not taken up, there is a need for making the energy consumed by a current-circulating resistor for the anode reactor. Therefore, given a large stored energy, the loss at the current-circulating resistor becomes large, leading to a larger loss of the power conversion device.

Further, since an increased loss of the current-circulating resistor causes the capacity of the current-circulating resistor to increase as well so that the current-circulating resistor increases in volume, the inverter stack becomes larger in scale. Besides, if fins for cooling use are attached to enlarge the allowable capacity of the current-circulating resistor, the inverter stack is further increased in scale.

With the inverter stack increased in scale, a floating inductance of the current-circulating circuit of the anode reactor is increased, leading to an increased voltage leap at turn-off of the self arc-suppression type semiconductor element and at reverse recovery of the free wheeling diode. As a result of this, there arises a need for using a self-exciting semiconductor element and a free wheedling diode both of higher breakdown voltages, or a need for additionally providing an overvoltage-protecting clamp circuit. Similarly, also in a case where the switching frequency of the switching element is increased, since the number of times the energy of the anode reactor is consumed by the current-circulating resistor increases in response to the frequency, there arises a need for increasing the capacity of the resistor, leading to an increased scale.

Further, in a current-limiting reactor for restraining fault currents, since the energy of the current-limiting reactor is consumed by the resistor at a high-amount current interruption of the semiconductor element or the circuit breaker as in the case of the anode reactor of the self-exciting converter, the capacity of the resistor is increased, leading to an increased scale as a problem.

In this connection, International Publication (WO 2006/003936) pamphlet describes that providing a higher-resistance pn diode makes it possible to eliminate the resistor connected in parallel to the anode reactor of the self-exciting converter. In this case, the higher resistance is achieved by thickening a drift layer of the diode.

Meanwhile, a relationship between drift layer thickness and on-voltage in a SiC pn diode is that the on-voltage increases with increasing thickness of the drift layer as shown in Fig. 5 (see Proceedings of ISPSD '01 (International Symposium on Power Semiconductor Devices & ICs) pp. 27 - 30).

Referring to Fig. 5, it is inferred that setting the thickness of the drift layer to 300 µm or more allows the on-voltage to be set to 20 V or higher. Then, a 300 µm thickness of the drift layer of a diode using SiC semiconductor makes it theoretically implementable to achieve a breakdown voltage of 30 kV, while a 50 µm thickness of the drift layer makes it implementable to achieve a breakdown voltage of several kilovolts.

In this connection, when a high-resistance diode having an on-voltage of 20 V or more is used in a circuit requiring a diode whose breakdown voltage is 5 kV, it becomes necessary to use a diode whose breakdown voltage is 30 kV or more, six times higher than the required breakdown voltage, 5 kV. The formation time necessary for the drift layer of this diode becomes six times or more longer than that of the drift layer of a diode having a required breakdown voltage, so that the film deposition time becomes considerably longer, leading to a considerable cost increase.

Further, providing a higher-resistance diode using Si semiconductor involves as low a rated maximum junction temperature as about 125°C. Therefore, since the junction temperature goes beyond the rated maximum junction temperature due to heat generation during applying a current, the device needs to be increased in size. As a result, the device yield decreases to a large extent, leading to a large cost increase.

### SUMMARY OF INVENTION

### Technical Problem

Accordingly, an object of the present invention is to provide a pn diode which is small in size, low in price and high in on-resistance.

### Solution to Problem

In order to achieve the object, a pn diode of the present invention is a pn diode in which an on-resistance is set to 0.1 Qcm² or more by lifetime control and which is formed from a wide-gap semiconductor.

According to the pn diode of the invention, since the on-resistance is set to 0.1 Ωcm² or more, the on-resistance of a 1 cm² chip as an example becomes 0.1 Ω or more. Therefore, a current decay time in a circuit where it is connected in parallel to an anode reactor having an inductance of 10 µH is 10 µH/0.1 Ω = 100 µsec or less. Then, the current decay time of 100 µsec is equal to a dead time of 100 µsec resulting under the conditions of a carrier frequency of 1 kHz and a voltage modulation ratio of 0.8 in the switching circuits of the inverter, the chopper or the like.

On the other hand, if the decay time of the current is longer than the dead time, there is a possibility that the current may flow to the switching element without being limited by the anode reactor at the time of a next switching operation so as to go beyond the critical current rising rate of the switching element, causing the switching element to be broken down.

Accordingly, the on-resistance being 0.1 Ωcm² or more as in this invention makes it possible to avoid destruction of the switching element and keep its normal operation under the conditions of the carrier frequency of 1 kHz, the inductance of 10 µH of the anode reactor and the chip size of 1 cm². Further increasing the on-resistance allows the carrier frequency to be further increased.

Also according to this invention, since the on-resistance of the pn diode is controlled by lifetime control, the on-resistance can be set with high accuracy. According to this invention as well, since the pn diode is formed from a wide-gap semiconductor, the pn diode can be made higher in heat tolerance so as to be capable of high-amount applied current and high-frequency applied current.

When a current is interrupted by the switching circuit, the current that has flowed through the anode reactor in the parallel connected circuit then flows to the pn diode serving as a diode for a current-circulating circuit. An overvoltage by a product of this current flowing through the pn diode and the resistance of the pn diode is applied to the switching circuit. Therefore, a total of the overvoltage and the DC source voltage needs to be not more than the breakdown voltage of the switching section. For example, given an on-voltage of 400 V of the 100 (A/cm²) pn diode, the on-resistance of the pn diode is 4 Ωcm² (= 400/100). In the case where this pn diode having an on-resistance of 4 Ωcm² is used as the diode for a current-circulating circuit, if the pn diode is a 1 cm² chip and if a current of 1000 A/cm² flows to the pn diode, then a voltage of 4000 V in addition to the DC source voltage is applied to the switching circuit. Accordingly, if the DC source voltage is 3 kV, then the voltage applied to the switching element of the switching circuit is 7 kV. It then follows that a breakdown voltage of 6 kV of the switching element causes dielectric destruction of the switching element to occur, while a breakdown voltage of 8 kV of the switching element does not cause the dielectric destruction. Thus, upper-limit values of the on-resistance and the on-voltage of the diode for the current-circulating circuit vary depending on the breakdown voltage of the switching element and the magnitude of the conducting current. In order to avoid the dielectric destruction of the switching element, the upper-limit value of the on-voltage of the diode for the current-circulating circuit needs to be less than a value obtained by subtracting the DC source voltage from the breakdown voltage of the switching element.

A pn diode of one embodiment is a pn diode in which an on-voltage at a rated current applied is set to 20 V or more by lifetime control.

According to the pn diode of this embodiment, for example, given the rated current of 100 A, the on-resistance of the diode becomes 0.2 Ω or more. If the diode has a current path area of 1 cm², then the on-voltage in that case is 20 V or more. Therefore, in a circuit including parallel connection with an anode reactor having an inductance of 10 µH, the decay time constant becomes 50 µsec (= 10 µH/0.2 Ω) or less. Accordingly, the dead time of the inverter can be 50 µsec or less, and the carrier frequency can be 2 kHz or more.

With regard to a diode having an ordinary on-voltage, its on-voltage at an applied current is about 5 V at most, where the on-resistance of a 1 cm² chip diode having a rated current of 100 A becomes 0.05 Ω. In this case, if the inductance of the anode reactor connected in parallel to this diode is 10 µH, then the decay time constant becomes 200 µsec (= 10 µH/0.05 Ω). Accordingly, the dead time of the switching circuit needs to be 200 µsec or more. Further, a carrier frequency that satisfies this condition is 500 Hz. This frequency is quite a low frequency for an inverter. Even with this frequency, the inverter is usable depending on applications, but involves too large a filter. Moreover, when the rated current per unit area is even larger or when the on-voltage is smaller, the decay time of the circulating current of the anode reactor becomes even longer, making it difficult to put the inverter into practical use.

In a pn diode of one embodiment, the lifetime control is performed by electron beam irradiation.

According to the pn diode of this embodiment, since the lifetime of minority carriers within the pn diode can be shortened to a large extent by electron beam irradiation of high dose, the diffusion length of minority carriers becomes much shorter, so that the conductivity modulation at an applied current can be reduced to a large extent. As a result, the on-resistance of the pn diode during electron beam irradiation of high dose can be made much larger, compared with common diodes for rectification use.

In a pn diode of one embodiment, by the electron beam irradiation, the pn diode is irradiated with an electron beam at a dose of 3×10¹³ cm⁻² or more.

According to the pn diode of this embodiment, the on-resistance of the diode can be set to 0.2 Ωcm² or more by lifetime control, where the current decay time in a circuit including parallel connection with an anode reactor having an inductance of 10 µH is 10 µH/0.2 Ω = 50 µsec or less. Thus, it becomes possible to set the carrier frequency in the inverter to 2 kHz or more.

In addition, since increasing the electron beam dose causes the on-voltage of the pn diode to be higher, providing this pn diode as a diode for a current-circulating circuit allows the decay time of the circulating current to be shortened even without connection of a resistor for decaying the circulating current, so that the carrier frequency of the power conversion device can be increased. On the other hand, when the switching element in the power conversion device is turned off, the high on-voltage of the current-circulating diode is superimposed on the DC source voltage, thus giving rise to a need for a switching element of high breakdown voltage. Also, since the leap voltage becomes higher, the switching loss becomes larger. Therefore, the upper-limit value of the electron beam needs to be less than such a value that a value obtained by subtracting the DC source voltage from the breakdown voltage of the switching element becomes equal to the on-voltage of the pn diode.

In a pn diode of one embodiment, the wide-gap semiconductor is SiC.

According to the pn diode of this embodiment, since the pn diode is formed from SiC, which is a wide-gap semiconductor, the pn diode is so high in heat tolerance as to withstand high temperatures of, e.g., several hundreds °C or more, thus free from device destruction even though the diode is of high resistance. Further, the SiC pn diode of this embodiment, by virtue of its high heat tolerance, is usable without any heat sink attached to the diode.

In a pn diode of one embodiment, the wide-gap semiconductor is GaN.

According to the pn diode of this embodiment, since the pn diode is formed from GaN, which is a wide-gap semiconductor, the pn diode is so high in heat tolerance as to withstand high temperatures of, e.g., several hundreds °C or more, thus free from device destruction even though the diode is of high resistance.

In a pn diode of one embodiment, the wide-gap semiconductor is diamond.

According to the pn diode of this embodiment, since the pn diode is formed from diamond, which is a wide-gap semiconductor, the pn diode is so high in heat tolerance as to withstand high temperatures of, e.g., several hundreds °C or more, thus free from device destruction even though the diode is of high resistance.

An electric circuit device of one embodiment includes a parallel connected circuit in which the pn diode and a reactor are connected in parallel.

According to the electric circuit device of this embodiment, since the on-resistance of the pn diode is set to a high resistance of 0.1 Ωcm² or more by lifetime control, the circulating current by the reactor can be decayed by the on-resistance of the pn diode, making it possible to eliminate the need for any large current-circulating resistor, so that the device can be compacted to a large extent.

An electric circuit device of one embodiment comprises:
a series connected circuit in which a plurality of the pn diodes are connected in series; and
a reactor connected in parallel to the series connected circuit.

According to the electric circuit device of this embodiment, the series connected circuit in which a plurality of the pn diodes are connected in series and which is connected in parallel to the reactor is made even higher in resistance. Therefore, it becomes possible to further shorten the decay time of the circulating current by the reactor.

A power conversion device of one embodiment comprises:
a parallel connected circuit in which the pn diode and a reactor are connected in parallel; and
a switching section connected in series to the parallel connected circuit.

According to the power conversion device of this embodiment, the inverter circuit for one phase can be made up. Then, according to this embodiment, since the pn diode is of high resistance, the need for any current-circulating resistor can be eliminated, so that the floating inductance of the parallel connected circuit can be reduced and the overvoltage applied to the switching sections can be restrained to a low one. Further, since the voltage rising rate of the switching sections can be restrained to a low one, mis-triggering of the switching element can be prevented.

A semiconductor device of one embodiment comprises:
the pn diode;
a switching element;
a free wheeling diode connected in parallel to the switching element; and
an anode reactor, wherein
the anode reactor and the pn diode are connected in parallel.

According to the semiconductor device of this embodiment, since the pn diode is of high resistance, the need for any current-circulating resistor can be eliminated, so that the floating inductance can be reduced and the voltage leap at turn-off of the switching element and at reverse recovery of the free wheeling diode can be reduced. Therefore, the overvoltage applied to the switching element or the free wheeling diode can be restrained to a low one.

A semiconductor device of one embodiment comprises the pn diode and a GTO, wherein the pn diode and the GTO are accommodated in one package.

According to the semiconductor device of this embodiment, the component parts count is reduced as compared with cases where discrete component parts are combined together. Therefore, the semiconductor device can be improved in reliability, reduced in total cost, and decreased in size.

### Advantageous Effects of Invention

According to the pn diode of the invention, since the on-resistance of the pn diode is set to a high resistance of 0.1 Ωcm² or more by lifetime control, the circulating current by the reactor can be decayed by the on-resistance of the pn diode, making it possible to eliminate the need for any large current-circulating resistor, so that the device can be compacted to a large extent.

### BRIEF DESCRIPTION OF DRAWINGS

Fig. 1 is a characteristic chart showing a forward current-voltage characteristic of a SiC pn diode which is a first embodiment of the present invention;
Fig. 2 is a circuit diagram of a current-limiting circuit which is a second embodiment of the invention;
Fig. 3 is a circuit diagram showing a circuit for one phase in a three-phase inverter device which is a third embodiment of the invention;
Fig. 4 is a characteristic chart showing a forward characteristic K101 of a diode according to a prior art;
Fig. 5 is a characteristic chart showing a relationship between on-voltage and drift layer thickness of a SiC pn diode according to a prior art; and
Fig. 6 is a circuit diagram of a three-phase inverter circuit according to a prior art.

### DESCRIPTION OF EMBODIMENTS

Hereinbelow, the present invention will be described in detail by way of embodiments thereof illustrated in the accompanying drawings.

### (First Embodiment)

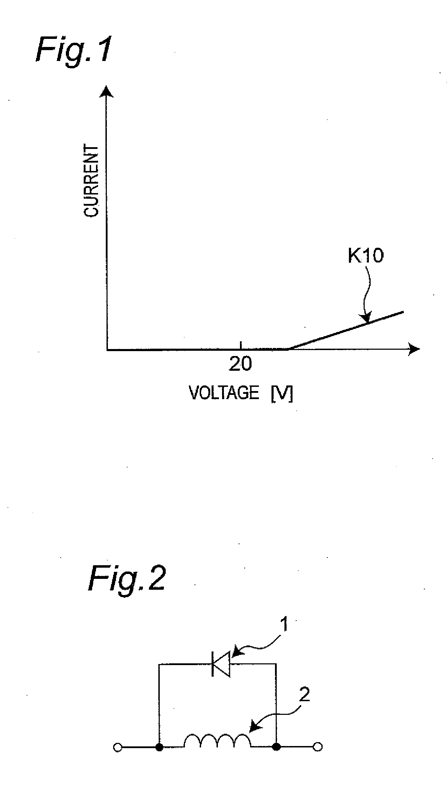

Fig. 1 shows a forward current-voltage characteristic K10 of a high-resistance SiC pn diode as a first embodiment of the invention.

The SiC pn diode of the first embodiment has been lifetime-controlled by irradiation of an electron beam of about 3×10¹³ cm⁻² to about 5×10¹⁶ cm⁻². That is, in the SiC pn diode of this first embodiment, minority-carrier lifetime of the pn diode has been considerably shortened by the electron beam irradiation so that its conductivity modulation has been reduced. The electron beam irradiation dose may be 5×10¹⁶ cm⁻² or more unless destruction occurs due to increased on-voltage of the diode.

As a result of this lifetime control, as shown by the current-voltage characteristic K10 in Fig. 1, in this SiC pn diode of the first embodiment, a current started to flow at about 32 V, showing an on-voltage of 50 V at an applied current of 100 A. The resistance at turn-on of the SiC pn diode in this case is 0.5 Ω. The conducting region of the SiC pn diode in this first embodiment is 0.4 cm², showing that the on-voltage can be made 14 times or more higher than an on-voltage of 3.5 V, which results from applying a current of 100 A through a SiC pn diode of a comparative example to which no electron beam is applied.

According to the SiC pn diode of this embodiment, since the on-resistance is increased by the lifetime control so as to be 0.2 Ωcm², it becomes possible to eliminate the resistor, for example, in an electric circuit device in which series connection of a diode and a resistor has conventionally been used. As a result, it becomes possible to achieve a considerable downsizing of the electric circuit device. Further, the SiC pn diode of this embodiment, which is made higher in resistance by the lifetime control technique, allows its resistance to be increased with good controllability with less variations in the resistance value. In addition, with regard to the SiC diode even with an on-resistance of about 0.1 Ωcm² or with an on-voltage of 20 V or more at a rated current applied, similar effects can be expected.

The SiC pn diode of this embodiment, which is formed from SiC that is a wide-gap semiconductor, is higher in heat tolerance than conventional Si pn diodes, withstanding high temperatures of, for example, several hundreds °C or higher, so that device destruction never occurs even if the diode is made high-resistance. Also, the SiC pn diode of this embodiment, by virtue of its high heat tolerance, is usable without any heat sink attached to the diode. The high-resistance SiC pn diode of this embodiment also has a reverse breakdown voltage of 8 kV.

Although the SiC pn diode of this embodiment employs a wide-gap semiconductor of SiC, yet such a wide-gap semiconductor as GaN or diamond may also be used, in which case also high heat tolerance can be obtained. Using a wide-gap semiconductor makes it possible to form a diode which is high in heat tolerance and capable of high-amount applied current or high-frequency applied current.

Also in the SiC pn diode of this embodiment, although electron beam irradiation of high irradiation dose is applied for the lifetime control to increase the resistance, the lifetime control may also be performed by heavy metal diffusion of Au, Pt or the like or irradiation of ions or molecules of protons, He or the like. In this case also, the minority-carrier lifetime can be shortened and the conductivity modulation can be reduced, so that a higher-resistance diode can be obtained.

The SiC pn diode of this embodiment has a reverse breakdown voltage of 8 kV. However, a pn diode designed for a reverse breakdown voltage of 10 kV or more is subject to a larger effect of the lifetime control such as electron beam irradiation, allowing a larger on-voltage or on-resistance to be obtained, so that the pn diode can be made higher in resistance.

### (Second Embodiment)

Next, Fig. 2 shows a circuit diagram of a current-limiting circuit which is a second embodiment of the invention. This current-limiting circuit is a parallel circuit in which a SiC pn diode 1 and a current-limiting reactor 2 are connected in parallel. The SiC pn diode 1 has been lifetime-controlled by electron beam irradiation of high irradiation dose, so that the on-resistance has been set to 1 Ω.

This current-limiting circuit is connected in series to the system. In event of a short-circuiting or other faults in the system to which the current-limiting circuit is connected, a current due to the fault is limited by the current-limiting reactor 2, by which a current-limiting is fulfilled. Then, when the system in which the fault has occurred is cut off, or when the system has recovered from the fault, the current that has flowed through the current-limiting reactor 2 is circulated to the SiC pn diode 1 connected in parallel to the current-limiting reactor 2. Thus, the system can be prevented from being burdened with overvoltages due to the current-limiting reactor 2.

In this connection, for conventional current-limiting circuits, it has been necessary to connect the series connection unit of a diode and a resistor in parallel to the current-limiting reactor. In contrast to this, in the current-limiting circuit of this second embodiment, lifetime control of the SiC pn diode 1 is performed by electron beam irradiation of high irradiation dose so that the SiC pn diode 1 is made to have a high on-resistance as described above. Therefore, the need for connecting a resistor in series to the SiC pn diode 1 is eliminated, so that the electric circuit device including this current-limiting circuit can be compacted.

Also, in this current-limiting circuit, no resistor is connected in series to the SiC pn diode 1. Therefore, the interconnecting line of the current-circulating circuit for circulating a reactor current can be shortened so that the floating inductance can be reduced. As a result, a system voltage leap by the current-limiting circuit can be reduced to 1100 V to 100 V.

In addition, although one SiC pn diode 1 is connected in parallel to the reactor 2 in the current-limiting circuit of this second embodiment, yet it is also possible to connect two or more SiC pn diodes 1 in parallel to the reactor 2.

### (Third Embodiment)

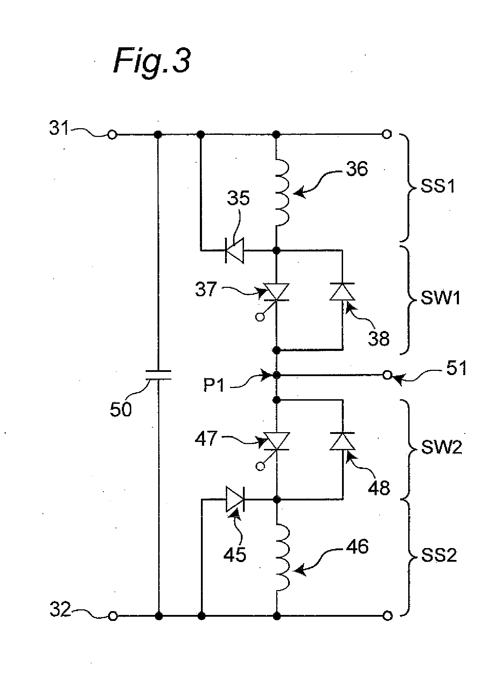

Next, a one-phase portion of a three-phase inverter device which is a power semiconductor device according to a third embodiment of the invention is described with reference to the circuit diagram of Fig. 3.

Referring to Fig. 3, between a positive terminal 31 and a negative terminal 32 of a DC input power source is connected a series connection unit in which a series snubber circuit SS1, a first switching circuit SW1 and a second switching circuit SW2, and a series snubber circuit SS2 are connected in this order. This series connection unit forms an inverter circuit for one phase.

Although not shown in Fig. 3, another inverter circuit for another phase constructed by a circuit similar to the inverter circuit for one phase is also connected between the positive terminal 31 and the negative terminal 32, thus making up a three-phase inverter device. Also, a capacitor 50 is connected between the positive terminal 31 and the negative terminal 32. The series snubber circuits SS1, SS2 and the first, second switching circuits SW1, SW2 do not necessarily need to be connected in this order between the positive terminal 31 and the negative terminal 32, and may be connected in any arbitrary order. Also, the series snubber circuit may be one in number. These are applicable also to the series snubber circuits, the first switching circuits and the second switching circuits for the other phases.

The first, second switching circuits SW1, SW2 are formed of antiparallel connection units made up of Si- or SiC-semiconductor GTOs 37, 47, which are switching elements, and Si- or SiC-semiconductor free wheeling diodes 38, 48, respectively. It is noted that switching circuits for the other phases, which are not shown in Fig. 3, have a similar construction.

The first, second switching circuits SW1, SW2 are controlled by control signals applied from a unshown known control circuit to gates of the GTOs 37, 47, respectively, by which an AC output AC is obtained from a connecting point P1 of the switching circuit SW1 and the switching circuit SW2. The circuit shown in Fig. 3 is operable also as a converter when an alternating current is inputted to a terminal 51 of the AC output AC. In this case, DC outputs can be obtained at the terminals 31, 32 of a DC input power source. The series snubber circuits SS1, SS2 have anode reactors 36, 46 including coils or other inductors, and SiC pn diodes 35, 45 connected in parallel to the anode reactors 36, 46, respectively.

These SiC pn diodes 35, 45 are wide-gap semiconductor pn diodes using SiC (silicon carbide), which is a wide-gap semiconductor (hereinafter, the wide-gap semiconductor pn diodes will be abbreviated as SiC diodes). Although GaN (gallium nitride) or diamond or the like may also be adopted as the wide-gap semiconductor, this embodiment is described on a SiC diode as an example in which SiC is adopted.

One terminal of the anode reactor 36 is connected to the positive terminal 31, while the other terminal is connected to the first switching circuit SW1. When the GTO 37 of the first switching circuit SW1 is turned on, a current derived from the DC input power source flows through the anode reactor 36 to the GTO 37. The anode reactor 36 moderates the rising characteristic of the current that flows into the GTO 37 so that the current flowing into the GTO 37 is reduced to below a critical current rising rate of the GTO 37.

When the GTO 37 is turned off, a current by electromagnetic energy stored in the anode reactor 36 flows through the SiC diode 35, being transformed into heat by the high-resistance SiC diode 35 and consumed as it is. The circulating current of the anode reactor 36 is decayed by the time when the GTO 37 is next turned on.

The SiC diodes 35, 45 included in the series snubber circuits SS1, SS2 of this third embodiment have a drift layer thickness of 70 µm and a breakdown voltage of 8 kV. These SiC diodes 35, 45 are lifetime-controlled by electron beam irradiation of high irradiation dose. Although electron beam irradiation is applied for the lifetime control of the SiC diodes 35, 45 in this third embodiment, the lifetime control may also be performed by heavy metal diffusion, irradiation of protons, or the like. In this third embodiment also, an electron beam dose for the electron beam irradiation was set to about 3×10¹³ cm⁻² to 5×10¹⁶ cm⁻². As a result of this, the SiC diodes 35, 45 showed an on-voltage of 110 V at an applied current of 110 A. In addition, the electron beam dose for irradiation in the lifetime control may also be further larger than about 5×10¹⁶ cm⁻². Besides, the drift layer thickness may be set as thick as 100 µm or more, while electron beam irradiation is applied to set the on-voltage higher.

In this case, the on-resistance of the SiC diodes 35, 45 is 1.1 Ω.

With a 10 µH inductance of the anode reactors 36, 46, a decay time of the circulating current is 9.1 µsec, where operations at 11 kHz or more are also possible. In addition, when the high-resistance SiC diodes 35, 45 of the series snubber circuits SS1, SS2 are connected in series in some plural number, respectively, the resistance becomes even higher, so that the decay time of the circulating current can be further shortened, making it possible to achieve even higher frequencies. Also, by increasing the quantity of lifetime control, for example, by increasing the electron beam dose of irradiation, it becomes possible to further increase the on-resistance, so that a higher-frequency inverter can be achieved.

In a concrete example of this third embodiment, when a current of 100 A was interrupted by the GTOs 37, 47 with a voltage of 4000 V of the DC input power source, an overvoltage generated in the GTOs 37, 47 was about 4850 V. In contrast to this, with the construction using the diode 105 and the resistor 103 in the current-circulating circuit of the series snubber circuits of the prior art example shown in Fig. 6, when the current of 100 A was interrupted by the GTO 107 with the DC input voltage of 4000 V, similar to that of the above case, the overvoltage generated in the GTO 107 was about 6700 V. Therefore, according to this third embodiment, a voltage leap upon current interruption is about 1/3.2 of the prior-art example counterpart. Thus, according to the three-phase inverter device of the third embodiment, since overvoltages can be reduced, it becomes possible to use device elements of low breakdown voltages, allowing the device to be lowered in price.

Also in this third embodiment, the GTO 37 of the switching circuit SW1, the free wheeling diode 38, the diode 35 of the series snubber circuit SS1, the GTO 47 of the switching circuit SW2, the free wheeling diode 48 and the diode 45 of the series snubber circuit SS2 are accommodated in one package. As a result of this, connecting conductor lines of the GTO 37 and the free wheeling diode 38 to the current-circulating diode 35 are shortened, and moreover connecting conductor lines of the GTO 47 and the free wheeling diode 48 to the current-circulating diode 45 are shortened.

By such shortening of the conductor lines as shown above, the floating inductance was further reduced, so that the overvoltage was able to be further reduced. Since the three elements (GTO of the switching circuit, free wheeling diode, and diode of the series snubber circuit) were built in a package, the overvoltage at current interruption was able to be reduced from 4850 V to 4350 V, and moreover the voltage leap at current interruption was able to be further reduced to 1/2.4 (i.e., 350/850). Furthermore, because the floating inductance was able to be reduced, the voltage rising rate of the GTOs decreased, so that mis-triggering of the GTOs was able to be prevented.

Also, by the GTOs and the diodes being accommodated in one package, the component parts count is reduced as compared with cases where discrete component parts are combined together. Therefore, the inverter device can be improved in reliability, reduced in total cost, and decreased in size.

Also in this third embodiment, the GTOs 37, 47 serving as switching elements are provided by SiC-GTOs, and the free wheeling diodes 38, 48 are provided by SiC diodes. That is, all the semiconductor elements are formed from-SiC semiconductor and accommodated in one package. As a result, it becomes implementable to fulfill package cooling with one heat sink, allowing the cooling device to be simplified, so that the inverter device can be simplified in structure and reduced in size to a large extent.

The pn diodes of the invention are applicable also to circuits in which a diode and a resistor are connected in series in step-up choppers, step-down choppers, step-up/down choppers and the like, in addition to the above-described current-limiting circuits as in the second embodiment and snubber circuits of the inverter device as in the third embodiment. Also, although the foregoing embodiments have been described primarily on SiC as the wide-gap semiconductor, yet the invention is applicable to pn diodes formed from highly heat-tolerant wide-gap semiconductors such as GaN and diamond as well.

In addition, although the foregoing embodiments have been shown on a case in which the gate terminal of a GTO is present on the cathode side, yet GTOs in which the gate terminal is present on the anode side have similar effects.

## Claims

1. A pn diode in which an on-resistance is set to 0.1 Ωcm² or more by lifetime control and which is formed from a wide-gap semiconductor.

2. A pn diode in which an on-voltage at a rated current applied is set to 20 V or more by lifetime control.

3. The pn diode as claimed in Claim 1 or 2, wherein
the lifetime control is performed by electron beam irradiation.

4. The pn diode as claimed in Claim 3, wherein
by the electron beam irradiation, the pn diode is irradiated with an electron beam at a dose of 3×10¹³ cm⁻² or more.

5. The pn diode as claimed in any one of Claims 1 to 4, wherein
the wide-gap semiconductor is SiC.

6. The pn diode as claimed in any one of Claims 1 to 4, wherein
the wide-gap semiconductor is GaN.

7. The pn diode as claimed in any one of Claims 1 to 4, wherein
the wide-gap semiconductor is diamond.

8. An electric circuit device including a parallel connected circuit in which the pn diode (1) as defined in Claim 1 and a reactor (2) are connected in parallel.

9. An electric circuit device comprising:
a series connected circuit in which a plurality of the pn diodes (1) as defined in Claim 1 or 2 are connected in series; and
a reactor (2) connected in parallel to the series connected circuit.

10. A power conversion device comprising:
a parallel connected circuit (SS1, SS2) in which the pn diode as defined in Claim 1 or 2 and a reactor are connected in parallel; and
a switching section (SW1, SW2) connected in series to the parallel connected circuit (SS1, SS2).

11. A semiconductor device comprising:
the pn diode as defined in Claim 1 or 2;
a switching element (37, 47) ;
a free wheeling diode (38, 48) connected in parallel to the switching element (37, 47); and
an anode reactor (36, 48), wherein
the anode reactor (36, 48) and the pn diode (35, 45) are connected in parallel.

12. A semiconductor device which comprises the pn diode as defined in Claim 1 or 2 and a GTO, wherein the pn diode (35, 45) and the GTO (37, 47) are accommodated in one package.
